(19)

**Europäisches Patentamt**
**European Patent Office**
**Office européen des brevets**

(11) **EP 4 293 827 A1**

(12) **EUROPEAN PATENT APPLICATION**

(43) Date of publication:
**20.12.2023 Bulletin 2023/51**

(21) Application number: **22212893.6**

(22) Date of filing: **12.12.2022**

(51) International Patent Classification (IPC):
*H01Q 5/321* (2015.01)  *H01Q 15/00* (2006.01)
*H01Q 15/22* (2006.01)  *G01N 27/22* (2006.01)
*G01N 21/3581* (2014.01)

(52) Cooperative Patent Classification (CPC):
**G01N 27/226; G01N 15/1434; G01N 21/7746;**
**G01N 27/22; H01Q 5/321; H01Q 15/0086;**
**H01Q 15/22;** G01N 21/21; G01N 21/3581

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **15.06.2022  IN 202221034377**

(71) Applicant: **Tata Consultancy Services Limited**
**Maharashtra (IN)**

(72) Inventors:
• **CHAUDHURI, ANIRBAN**
  **560066 Bangalore - Karnataka (IN)**

• **PAL, PARAMA**
  **560066 Bangalore - Karnataka (IN)**
• **RAI, BEENA**
  **411013 Pune - Maharashtra (IN)**

(74) Representative: **Goddar, Heinz J.**
**Boehmert & Boehmert**
**Anwaltspartnerschaft mbB**
**Pettenkoferstrasse 22**
**80336 München (DE)**

Remarks:
Amended claims in accordance with Rule 137(2) EPC.

(54) **DESIGNING AN OPTIMAL DUAL-BAND METAMATERIAL POLARIZATION CONVERTER FOR REFRACTIVE INDEX SENSING**

(57) This disclosure relates generally to methods and systems for designing an optimal dual-band metamaterial polarization converter for refractive index sensing applications. Most of the existing techniques for designing the metamaterial-based polarization converters operating at very high frequency range limits the sensing performance and increases fabrication complexity. In the design of the optimal dual-band metamaterial polarization converter, first a circular split-ring resonator (SRR) as a unit cell is designed. Secondly, the two capacitive gaps of the top layer, are aligned at 180 degrees with respect to each other and at 45 degrees with respect to X-axis and Y-axis. Lastly, step-by-step tuning the one or more key design parameters of the SRR, is performed until an optimum frequency response is obtained, to obtain the optimal dual-band metamaterial polarization converter.

FIGS. 3A-3C

**Description**

CROSS-REFERENCE TO RELATED APPLICATIONS AND PRIORITY

The present application claims priority to Indian application no. 202221034377, filed on June 15, 2022.

TECHNICAL FIELD

The disclosure herein generally relates to the field of polarization converters and more specifically to methods and systems for designing an optimal dual-band metamaterial polarization converter for refractive index sensing applications.

BACKGROUND

Polarization converters are passive devices that changes a polarization state of an incoming radiation to a different polarization state by virtue of multiple wave-matter interactions. The polarization converters find a variety of real-world applications in the field of sensing, spectroscopy, imaging, antennas, communication, and so on. Most of the polarization convertors uses a metamaterial (artificially engineered material with sub-wavelength topological features) based on split-ring resonators as a unit cell in various shapes, designs, and structures, that exhibit a desired frequency response suitable to work for the variety of the real-world applications. For example, the polarization converter which operates in a Terahertz (THz) frequency range is used as a Refractive Index (RI) sensor in bio-sensing applications

Most of the existing techniques for designing the metamaterial-based polarization converters operating at very high frequency range have at least one of the two characteristics: (i) focused on generating a broadband cross-polarization response and (ii) use of a multiple edge-coupled split-ring resonators (SRRs) as their metamaterial unit cell. However, using the polarization converter with broadband response in sensing applications limits the sensor performance, which is quantified by the Figure of Merit (FoM)/Q-factor, due to the large bandwidth of the broadband responses. Using the multiple edge coupled SRRs as the unit cell increases fabrication complexity as there are stringent tolerances related to the separations and orientations between each element. Moreover, such structures will increase the dimensions of the metamaterial array.

SUMMARY

Embodiments of the present disclosure present technological improvements as solutions to one or more of the above-mentioned technical problems recognized by the inventors in conventional systems.

In an aspect, a processor-implemented method for designing an optimal dual-band metamaterial polarization converter is provided. The method including the steps of: designing a circular split-ring resonator (SRR) as a unit cell, having initial values of one or more key design parameters of the SRR, using a simulation model, wherein the SRR comprises a substrate layer sandwiched between a top layer and a bottom layer, and wherein the top layer comprises two capacitive gaps; aligning the two capacitive gaps of the top layer, at 180 degrees with respect to each other and at 45 degrees with respect to X-axis and Y-axis, to enable a cross- polarization conversion independent of a polarization direction of an incoming electromagnetic wave; step-by-step tuning the initial values of the one or more key design parameters of the SRR, until an optimum frequency response is satisfied, to obtain the optimal dual-band metamaterial polarization converter with optimal values of the one or more key design parameters of the SRR; checking a stability of the optimal dual-band metamaterial polarization converter using a parametric study, by varying the one or more key design parameters, within a predefined range; introducing a target layer on the optimal dual-band metamaterial polarization converter, to calculate one or more sensing performance metrics from a shifted response, wherein the target layer comprises a plurality of samples with varying refractive index (RI) values; and validating the shifted response of the optimal dual-band metamaterial polarization converter, using an equivalent circuit model of the optimal dual-band metamaterial polarization converter, based on the calculated one or more sensing performance metrics.

In another aspect, a system for designing an optimal dual-band metamaterial polarization converter is provided. The system includes: a memory storing instructions; one or more Input/Output (I/O) interfaces; and one or more hardware processors coupled to the memory via the one or more I/O interfaces, wherein the one or more hardware processors are configured by the instructions to: design a circular split-ring resonator (SRR) as a unit cell, having initial values of one or more key design parameters of the SRR, using a simulation model, wherein the SRR comprises a substrate layer sandwiched between a top layer and a bottom layer, and wherein the top layer comprises two capacitive gaps; align the two capacitive gaps of the top layer, at 180 degrees with respect to each other and at 45 degrees with respect to X-axis and Y-axis, to enable a cross- polarization conversion independent of a polarization direction of an incoming electromagnetic wave; step-by-step tuning the initial values of the one or more key design parameters of the SRR, until an optimum frequency response is satisfied, to obtain the optimal dual-band metamaterial polarization converter with optimal values of the one or more key design parameters of the SRR; check a stability of the optimal dual-band metamaterial polarization converter using a parametric study, by varying the one or more key design parameters, within a predefined range; introduce a target layer on the optimal dual-band metamaterial polarization converter, to calculate one or more sensing performance metrics from a shifted response, wherein the target layer comprises a plurality of samples with varying refractive index (RI) values; and validate the shifted response of the optimal dual-band metamaterial polarization converter, using an equivalent circuit model of the optimal dual-band metamaterial polarization converter, based on the calculated one or more sensing performance metrics.

In yet another aspect, there is provided a computer program product comprising a non-transitory computer readable medium having a computer readable program embodied therein, wherein the computer readable program, when executed on a computing device, causes the computing device to: design a circular split-ring resonator (SRR) as a unit cell, having initial values of one or more key design parameters of the SRR, using a simulation model, wherein the SRR comprises a substrate layer sandwiched between a top layer and a bottom layer, and wherein the top layer comprises two capacitive gaps; align the two capacitive gaps of the top layer, at 180 degrees with respect to each other and at 45 degrees with respect to X-axis and Y-axis, to enable a cross- polarization conversion independent of a polarization direction of an incoming electromagnetic wave; step-by-step tuning the initial values of the one or more key design parameters of the SRR, until an optimum frequency response is satisfied, to obtain the optimal dual-band metamaterial polarization converter with optimal values of the one or more key design parameters of the SRR; check a stability of the optimal dual-band metamaterial polarization converter using a parametric study, by varying the one or more key design parameters, within a predefined range; introduce a target layer on the optimal dual-band metamaterial polarization converter, to calculate one or more sensing performance metrics from a shifted response, wherein the target layer comprises a plurality of samples with varying refractive index (RI) values; and validate the shifted response of the optimal dual-band metamaterial polarization converter, using an equivalent circuit model of the optimal dual-band metamaterial polarization converter, based on the calculated one or more sensing performance metrics.

In an embodiment, the substrate layer is made up of a di-electric material with a predefined dielectric constant; the top layer and the bottom layer are made up of a metal; and the bottom layer is a reflective layer.

In an embodiment, the one or more key design parameters of the SRR comprises: an inner radius of the top layer, an outer radius of the top layer, a width of the top layer, a thickness of the substrate layer, and a width of each of the two capacitive gaps of the top layer.

In an embodiment, step-by-step tuning the initial values of the one or more key design parameters of the SRR, comprises: (i) randomly adjusting an initial value of the width of the top layer, to obtain a successive value of the width of the top layer, by fixing the initial value of the inner radius of the top layer; (ii) calculating a successive value of the outer radius of the top layer, based on the initial value of the inner radius of the top layer and the successive value of the width of the top layer; (iii) iteratively changing the thickness of the substrate layer; (iv) iteratively changing the width of each of two capacitive gaps of the top layer; (v) obtaining a successive value of the inner radius of the top layer; and (vi) repeating the steps (i) through (v), considering the successive value of the width of the top layer as the initial value and the successive value of the inner radius of the top layer as the initial value, until the optimum frequency response is satisfied.

In an embodiment, the optimum frequency response comprises a co-polar reflection coefficient close to zero and a cross-polar reflection coefficient close to 1, at resonant frequencies.

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 is an exemplary block diagram of a system for designing an optimal dual-band metamaterial polarization converter, in accordance with some embodiments of the present disclosure.
FIG. 2 illustrates exemplary flow diagram of a processor-implemented method for designing an optimal dual-band metamaterial polarization converter, in accordance with some embodiments of the present disclosure.
FIGS. 3A, 3B and 3C shows a top view, a bottom view, and a side view of a circular split-ring resonator (SRR) respectively, in accordance with some embodiments of the present disclosure.
FIG. 4A is a graph showing an exemplary comparison of a co-polar reflection coefficient and a cross-polar reflection coefficient with an operating frequency of the SRR, in accordance with some embodiments of the present disclosure.
FIG. 4B is a graph showing an exemplary comparison of a polarization conversion ratio (PCR) with the operating frequency of the SRR, in accordance with some embodiments of the present disclosure.

FIG. 5A is a graph showing an exemplary shift in the PCR response when a healthy and a cancerous MCF-7 cell is introduced on a top layer of the SRR, at first resonance, in accordance with some embodiments of the present disclosure.

FIG. 5B is a graph showing an exemplary shift in the PCR response when the healthy and the cancerous MCF-7 cell is introduced on the top layer of the SRR, at second resonance, in accordance with some embodiments of the present disclosure.

FIG. 6A is a graph showing an exemplary comparison of the co-polar reflection coefficient response of the optimal dual-band metamaterial polarization converter without an analyte layer, and the resultant response of an equivalent circuit model, in accordance with some embodiments of the present disclosure.

FIG. 6B is a graph showing an exemplary comparison of the co-polar reflection coefficient response of the optimal dual-band metamaterial polarization converter with the 1 $\mu$m analyte layer having the cancerous MCF-7 cells, and the resultant response of the equivalent circuit model, in accordance with some embodiments of the present disclosure.

## DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

The present disclosure solves the technical problems in the art for designing an optimal dual-band metamaterial polarization converter that operates at a desired frequency, achieving the cross-polarization conversion. The optimal dual-band metamaterial polarization converter is designed with a single split-ring generator as a unit cell and hence the fabrication of the optimal dual-band metamaterial polarization converter is simple, less in size and the dimensions.

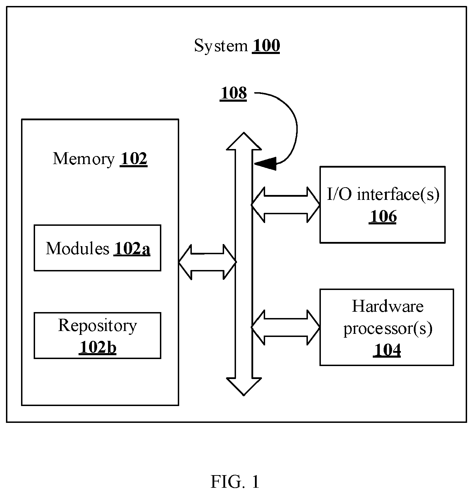

Referring now to the drawings, and more particularly to FIG. 1 through FIG. 6B, where similar reference characters denote corresponding features consistently throughout the figures, there are shown preferred embodiments and these embodiments are described in the context of the following exemplary systems and/or methods.

FIG. 1 is an exemplary block diagram of a system 100 for designing an optimal dual-band metamaterial polarization converter, in accordance with some embodiments of the present disclosure. In an embodiment, the system 100 includes or is otherwise in communication with one or more hardware processors 104, communication interface device(s) or input/output (I/O) interface(s) 106, and one or more data storage devices or memory 102 operatively coupled to the one or more hardware processors 104. The one or more hardware processors 104, the memory 102, and the I/O interface(s) 106 may be coupled to a system bus 108 or a similar mechanism.

The I/O interface(s) 106 may include a variety of software and hardware interfaces, for example, a web interface, a graphical user interface, and the like. The I/O interface(s) 106 may include a variety of software and hardware interfaces, for example, interfaces for peripheral device(s), such as a keyboard, a mouse, an external memory, a plurality of sensor devices, a printer and the like. Further, the I/O interface(s) 106 may enable the system 100 to communicate with other devices, such as web servers and external databases.

The I/O interface(s) 106 can facilitate multiple communications within a wide variety of networks and protocol types, including wired networks, for example, local area network (LAN), cable, etc., and wireless networks, such as Wireless LAN (WLAN), cellular, or satellite. For the purpose, the I/O interface(s) 106 may include one or more ports for connecting a number of computing systems with one another or to another server computer. Further, the I/O interface(s) 106 may include one or more ports for connecting a number of devices to one another or to another server.

The one or more hardware processors 104 may be implemented as one or more microprocessors, microcomputers, microcontrollers, digital signal processors, central processing units, state machines, logic circuitries, and/or any devices that manipulate signals based on operational instructions. Among other capabilities, the one or more hardware processors 104 are configured to fetch and execute computer-readable instructions stored in the memory 102. In the context of the present disclosure, the expressions 'processors' and 'hardware processors' may be used interchangeably. In an embodiment, the system 100 can be implemented in a variety of computing systems, such as laptop computers, portable computers, notebooks, hand-held devices, workstations, mainframe computers, servers, a network cloud and the like.

The memory 102 may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes. In an embodiment, the memory 102 includes a plurality of modules 102a and a repository 102b for storing data processed, received, and generated by one or more of the plurality of modules 102a. The plurality of modules 102a may include routines, programs, objects, components, data structures, and so on, which perform particular tasks or implement particular abstract data types.

The plurality of modules 102a may include programs or computer-readable instructions or coded instructions that supplement applications or functions performed by the system 100. The plurality of modules 102a may also be used as, signal processor(s), state machine(s), logic circuitries, and/or any other device or component that manipulates signals based on operational instructions. Further, the plurality of modules 102a can be used by hardware, by computer-readable instructions executed by the one or more hardware processors 104, or by a combination thereof. In an embodiment, the plurality of modules 102a can include various sub-modules (not shown in FIG. 1). Further, the memory 102 may include information pertaining to input(s)/output(s) of each step performed by the processor(s) 104 of the system 100 and methods of the present disclosure.

The repository 102b may include a database or a data engine. Further, the repository 102b amongst other things, may serve as a database or includes a plurality of databases for storing the data that is processed, received, or generated as a result of the execution of the plurality of modules 102a. Although the repository 102b is shown internal to the system 100, it will be noted that, in alternate embodiments, the repository 102b can also be implemented external to the system 100, where the repository 102b may be stored within an external database (not shown in FIG. 1) communicatively coupled to the system 100. The data contained within such external database may be periodically updated. For example, data may be added into the external database and/or existing data may be modified and/or non-useful data may be deleted from the external database. In one example, the data may be stored in an external system, such as a Lightweight Directory Access Protocol (LDAP) directory and a Relational Database Management System (RDBMS). In another embodiment, the data stored in the repository 102b may be distributed between the system 100 and the external database.

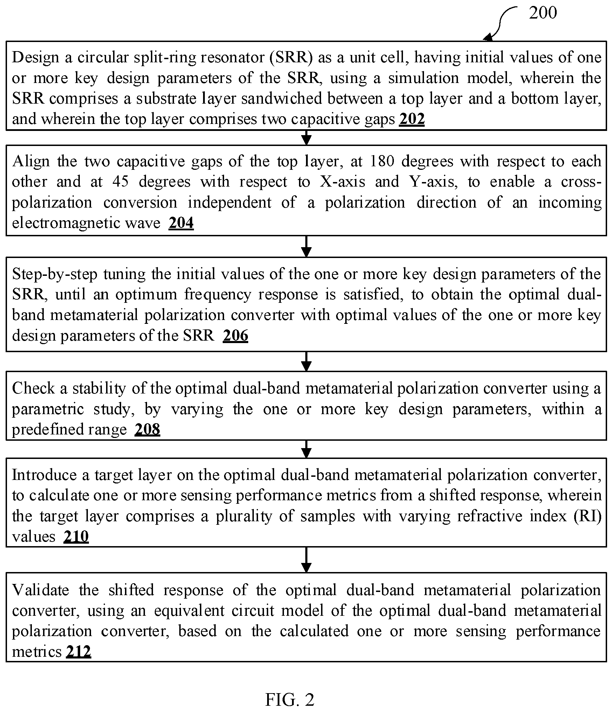

Referring to FIG. 2, components and functionalities of the system 100 are described in accordance with an example embodiment of the present disclosure. For example, FIG. 2 illustrates exemplary flow diagram of a processor-implemented method 200 for designing an optimal dual-band metamaterial polarization converter, in accordance with some embodiments of the present disclosure. Although steps of the method 200 including process steps, method steps, techniques or the like may be described in a sequential order, such processes, methods and techniques may be configured to work in alternate orders. In other words, any sequence or order of steps that may be described does not necessarily indicate a requirement that the steps be performed in that order. The steps of processes described herein may be performed in any practical order. Further, some steps may be performed simultaneously, or some steps may be performed alone or independently.

At step 202 of the method 200, the one or more hardware processors 104 of the system 100 are configured to design a single split-ring resonator (SRR) as a unit cell for designing the optimal dual-band metamaterial polarization converter. The shape of the SRR is circular as the circular SRR resonates at higher frequency compared to a square shaped SRR (due to higher current density). Hence the circular SRR can be operated at higher frequency with a smaller size.

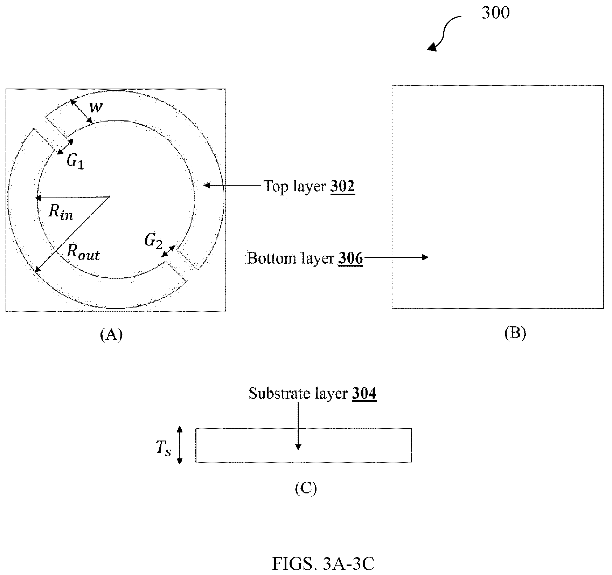

FIGS. 3A, 3B and 3C shows a top view, a bottom view, and a side view of a circular split-ring resonator (SRR) respectively, in accordance with some embodiments of the present disclosure. As shown in FIG. 3A-3C, the SRR 300 includes a top layer 302, a substate layer 304, and a bottom layer 306. The substate layer 304 is sandwiched between the top layer 302 and the bottom layer 306. Further, the top layer 302 includes two capacitive gaps ($G_1$ and $G_2$). In an embodiment, a width of each of the two capacitive gaps ($G_1$ and $G_2$) is same. In an embodiment, the top layer 302 and the bottom layer 306 are made up of metal in the form of metal rings, selected from a metallic group including but are not limited to gold, silver, copper, and aluminum. The metal rings act like an inductor. Further, the bottom layer 306 act as a reflective layer. In an embodiment, the substate layer 304 is made up of a di-electric material exhibiting a predefined di-electric constant. The di-electric material is selected from a di-electric material group including but are not limited to polyamide, silicon dioxide, silicon, and Polydimethylsiloxane (PDMS). If the di-electric material is polyamide, then the predefined di-electric constant of the polyamide should be 2.8.

The incoming electromagnetic wave induces a circular current in the top layer 302 (metal ring), which in turn creates a magnetic field (Inductive effect). By principle of electromagnetic induction, this magnetic field again induces a current in the bottom layer 306. The substate layer 304 acts as a waveguide which enables the propagation of the incoming electromagnetic waves through it. The bottom layer 306 covers the entire unit cell, preventing any transmission through it and thus act as a mirror for the incoming waves, hence the bottom layer 306 also called as the reflection layer. The incoming waves suffer multiple reflections in the bottom layer 306 and owing to the anisotropy due to the surface current distribution, the reflective waves suffer a change in their propagation direction achieving the cross-polarization conversion.

The two capacitive gaps ($G_1$ and $G_2$) when introduced between the top layer 302 and the bottom layer 306 (metal layers) regions introduce a capacitive effect. This capacitive effect along with the inductive effect gives rise to strong resonance. As a result, the SRR 300 behaves equivalent to an LC resonant circuit whose resonant frequency depends on an inductance (L) and a capacitance (C).

The SRR 300 is designed keeping in mind the one or more key design parameters, such that the size of the SRR 300 is smaller than an operating wavelength of an incoming electromagnetic wave. More specifically, the one or more key design parameters vary with respect to the desired response of the SRR 300. In an embodiment, the one or more key design parameters of the SRR 300 includes an inner radius ($R_{in}$) of the top layer 302, an outer radius ($R_{out}$) of the top layer 302, a width (w) of the top layer 302, a thickness ($T_s$) of the substrate layer 304, and a width ($W_g$, not shown in FIG. 3A-3C) of each of the two capacitive gaps ($G_1$ and $G_2$) of the top layer 302.

The one or more key design parameters include respective initial values at the initial design of the SRR 300. The initial values of the one or more key design parameters have to be optimized to achieve the desired response. Further, the other fixed design parameters of the SRR such as a thickness of the top layer 302, dimensions of the bottom layer 306, are fixed. In an embodiment, the thickness of the top layer 302 is 200 nanometers (nm). In an embodiment, the shape of the bottom layer 306 is square and the side length of the bottom layer 306 is 70 micrometers ($\mu$m).

At step 204 of the method 200, the one or more hardware processors 104 of the system 100 are configured to align the two capacitive gaps ($G_1$ and $G_2$) of the top layer 302, at 180 degrees with respect to each other and at 45 degrees with respect to X-axis and Y-axis. The alignment of the two capacitive gaps ($G_1$ and $G_2$) is to enable a cross-polarization conversion independent of a polarization direction of an incoming electromagnetic wave into the SRR 300.

The SRR 300 operates when the electric or magnetic dipole moment is in the direction of the incident electric or magnetic field. If the two capacitive gaps ($G_1$ and $G_2$) (electric dipoles) are aligned either with respect to the X-axis or the Y-axis, its operation would be limited to the case when the incident electric field is along the X-axis or the Y-axis axis respectively. Hence the two capacitive gaps ($G_1$ and $G_2$) are inclined at 45° with respect to both the X-axis and the Y-axis so that incident electric field propagating along either the X-axis or the Y-axis will have a component along the electric dipole direction and the SRR 300 will work irrespective of the polarization state of the incoming wave. A linear electromagnetic wave incident on the structure induces a current in the SRR 300 and the bottom layer 306. As the two capacitive gaps ($G_1$ and $G_2$) are aligned 45° with respect to the X- and the Y-axis, the incident wave can be either X or Y polarized.

At step 206 of the method 200, the one or more hardware processors 104 of the system 100 are configured to step-by-step tuning the initial values of the one or more key design parameters of the SRR 300. The step-by-step tuning is performed until an optimum frequency response is satisfied. The values of the one or more key design parameters at which the optimum frequency response is satisfied, are considered as optimal values for the one or more key design parameters. The SRR 300 with the optimal values for the one or more key design parameters is considered as the optimal dual-band metamaterial polarization converter.

In an embodiment, the optimum frequency response is satisfied when a co-polar reflection coefficient close to zero and a cross-polar reflection coefficient close to 1, at resonant frequencies. The step-by-step tuning of the initial values of the one or more key design parameters of the SRR 300, until the optimum frequency response is satisfied to obtain the optimal dual-band metamaterial polarization converter, is explained in detail in the below steps.

In an embodiment, in the first step, the initial value of the width (w) of the top layer 302, is randomly adjusted, to obtain a successive value of the width (w) of the top layer 302. This is done by fixing the initial value of the inner radius ($R_{in}$) of the top layer 302.

In the second step, a successive value of the outer radius ($R_{out}$) of the top layer 302, is calculated based on the initial value of the inner radius ($R_{in}$) of the top layer 302 and the successive value of the width (w) of the top layer 302 obtained in the first step. As the width (w) of the top layer 302 changes, the outer radius ($R_{out}$) of the top layer 302 automatically changes. The successive value of the outer radius ($R_{out}$) of the top layer 302 is calculated by adding the initial value of the inner radius ($R_{in}$) of the top layer 302 and the successive value of the width (w) of the top layer 302 obtained in the first step.

In the third step, the thickness ($T_s$) of the substrate layer 304 is iteratively checked. In the fourth step, the width ($W_g$) of each of the two capacitive gaps ($G_1$ and $G_2$) of the top layer 302 is iteratively checked. In the fifth step, a successive value of the inner radius ($R_{in}$) of the top layer 302 is calculated by subtracting the successive value of the width ($w$) of the top layer 302 from the successive value of the outer radius ($R_{out}$) of the top layer 302.

In each of the all the above five steps, the optimum frequency response is checked whether it is satisfied or not. If the optimum frequency response is obtained is satisfied at any above step, then the corresponding values of the one or more key design parameters at which the optimum frequency response are called the optimal values and the design of the corresponding SRR 300 is considered as the optimal dual-band metamaterial polarization converter.

If the optimum frequency response is not satisfied at any of the above steps, the steps one through fifth step are repeated, considering the successive value of the width ($w$) of the top layer 302 as the initial value and the successive value of the inner radius ($R_{in}$) of the top layer 302 as the initial value, until the optimum frequency response is satisfied. Thus, finally the design of the optimal dual-band metamaterial polarization converter is obtained. The obtained design of the metamaterial polarization converter is said to be dual-band as the polarization conversion occurs at two different frequencies.

At step 208 of the method 200, the one or more hardware processors 104 of the system 100 are configured check a stability of the optimal dual-band metamaterial polarization converter obtained at step 206 of the method 200.

The stability of the optimal dual-band metamaterial polarization converter is performed to check the dependency on the one or more key design parameters. In an embodiment, the stability of the optimal dual-band metamaterial polarization converter is checked using a parametric study, by varying the one or more key design parameters, at predefined range.

In an embodiment, the optimal dual-band metamaterial polarization converter obtained at step 206, or after stabilized at step 208 is used for different refractive index (RI) sensing applications. Further the optimal dual-band metamaterial polarization converter should operate at a particular frequency band in order to use for the different refractive index (RI) sensing applications. For example, if the optimal dual-band metamaterial polarization converter is used for bio sensing applications for example, to detect and distinguish samples of cancer cell from healthy cells, then it is preferable to operate at terahertz frequency range. Further an additional layer on top of the optimal dual-band metamaterial polarization converter is required in order to use it for different refractive index (RI) sensing applications.

At step 210 of the method 200, the one or more hardware processors 104 of the system 100 are configured to introduce a target layer on the optimal dual-band metamaterial polarization converter, to obtain the shifted response. The target layer is selected based on the type of application where the optimal dual-band metamaterial polarization converter is used. If the optimal dual-band metamaterial polarization converter is used as a biosensor for the refractive index (RI) sensing, then the target layer is an analyte layer. The analyte layer may have a plurality of samples with different refractive index (RI) values. In an embodiment, the target layer is introduced on the top layer of the optimal dual-band metamaterial polarization converter (more specifically on the top layer 302 of the SRR 300). Based on the shifted response by the optimal dual-band metamaterial polarization converter, the one or more sensing performance metrics are calculated to check the accuracy of the optimal dual-band metamaterial polarization converter for the specific application. The one or more sensing performance metrics includes but are not limited to a sensitivity and a figure-of-metric.

The sensitivity (***S***) is defined as the resonance frequency shift due to unity change in R.I. of the surrounding. The sensitivity (***S***) is mathematically expressed as in equation 1:

$$S = \frac{\Delta f}{\Delta n} \text{ -------------------------------------------- (1)}$$

Wherein the $\Delta f$ represents the resonance frequency shift and $\Delta n$ represents the change in R.I. of the surrounding media.

The figure-of-merit (***FoM***) is defined as the ratio of the sensitivity (***S***) to the 3-dB bandwidth. The figure-of-merit (***FoM***) is mathematically expressed as in equation 2:

$$FoM = \frac{S}{Bandwidth\ (3-dB)} \text{ --------------------------------------------}(2)$$

At step 212 of the method 200, the one or more hardware processors 104 of the system 100 are configured to validate the shifted response obtained at step 210 of the method 200 of the optimal dual-band metamaterial polarization converter, using an equivalent circuit model of the optimal dual-band metamaterial polarization converter. The equivalent circuit model of the optimal dual-band metamaterial polarization converter is obtained by representing the different components of the metamaterial (in other words the SRR of the optimal dual-band metamaterial polarization converter) with different electrical circuit components such as Resistors (R), Inductors (L), Capacitors (C), Transmission lines (TL), and Impedance (Z). For example, the top layer 302 is represented as a series RLC circuit, wherein the two capacitive gaps ($G_1$ and $G_2$) are represented by a capacitor (C), the metal layer portion of the top layer 302 is represented by the inductor (L), and the ohmic losses in the top layer 302 is represented by the resistor (R). The substrate layer 304 is represented by a transmission line, and the bottom layer 306 is represented by a ground, which signifies no transmission through it. The target layer added on top of the SRR for refractive index sensing, is also represented by the transmission line. The target layer also changes the capacitor (C) value of the top layer 302. All the component values of the equivalent circuit model are calculated using a gradient optimization technique.

Using the equivalent circuit model of the optimal dual-band metamaterial polarization converter, the one or more sensing performance metrics are calculated. The values of the one or more sensing performance metrics obtained from the equivalent circuit model are compared with the values of the one or more sensing performance metrics obtained at step 210, to validate the shifted response. The shifted response is found to be accurate from this validation, then the optimal dual-band metamaterial polarization converter with the corresponding target layer can be used for the specific RI applications.

In an embodiment, the design, fine tuning, checking the stability and the validation steps of the SRR of the invention are performed using a finite element method simulation model. Further, the equivalent circuit model is made using a circuit simulation model.

In accordance with the methods and systems of the present disclosure, the optimal dual-band metamaterial polarization converter is designed by fine-tuning the design parameters, to operate at a desired frequency, achieving the cross-polarization conversion. Hence the optimal dual-band metamaterial polarization converter is used in the applications but are not limited to the refractive index sensing applications such as biosensing, quality monitoring, and harmful chemical detection, and, spectroscopy, imaging, antennas, and communication.

The optimal dual-band metamaterial polarization converter is designed with a single split-ring generator as a unit cell and hence the fabrication of the optimal dual-band metamaterial polarization converter is simple, less in size and the dimensions. The design of the optimal dual-band metamaterial polarization converter in reflection mode reduces the size and fabrication complexity. Attributed to the direction of current flow in the SRR 300 and the bottom layer 306 at resonant frequencies, the optimal dual-band metamaterial polarization converter acts as an anisotropic material due to different impedance values along different directions. These variations in impedance enable the desired phase shift of the reflected electromagnetic wave, thereby achieving cross-polarization conversion.

Example scenario:

The design of the SRR 300 is implemented to design the optimal dual-band metamaterial polarization converter that operates at terahertz frequency, to use the optimal dual-band metamaterial polarization converter as the RI biosensor. The top layer 302 and the bottom layer 306 are made of gold metal. The substate layer 304 is made up of dielectric material polyamide. The step-by-step tuning of the design parameters are with the SRR (unit cell) dimensions of 40 $\mu$m $\times$ 40 $\mu$m and increased it up to 70 $\mu$m $\times$ 70 $\mu$m. The best optimal frequency response is observed at the optimal values obtained corresponding to the key design parameters are observed as below to obtain the optimal dual-band metamaterial polarization converter operating at 1 THz and 1.745 THz:

- The inner radius ($R_{in}$) of the top layer 302: 24 $\mu$m
- The outer radius ($R_{out}$) of the top layer 302: 33 $\mu$m
- The width ($w$) of the top layer 302: 9 $\mu$m
- The thickness ($T_s$) of the substrate layer 304: 8 $\mu$m
- The width ($W_g$)of each of the two capacitive gaps ($G_1$ and $G_2$): 1 $\mu$m

The parametric study is conducted by varying the width ($W_g$) of each of the two capacitive gaps ($G_1$ and $G_2$) from 1-4 $\mu$m in steps of 1 $\mu$m, and the width ($w$) of the top layer 302 from 8-9.5 $\mu$m in steps of 0.5 $\mu$m and the outer radius ($R_{out}$) of the top layer 302 from 32-33.5 $\mu$m in steps of 0.5 $\mu$m. The analyte layer in the target layer is introduced on the top layer 302 of the optimal dual-band metamaterial polarization converter (the SRR 300). The analyte layer contains the biological sample having different healthy and cancerous cells with different refractive index values (RIs). The thickness of the analyte layer is 1 $\mu$m. More specifically, the detection of cancerous MCF-7 cells is demonstrated. The R.I. of the healthy MCF-7 cells observed is 1.36. For cancerous MCF-7 cells, the R.I. is observed as 1.401.

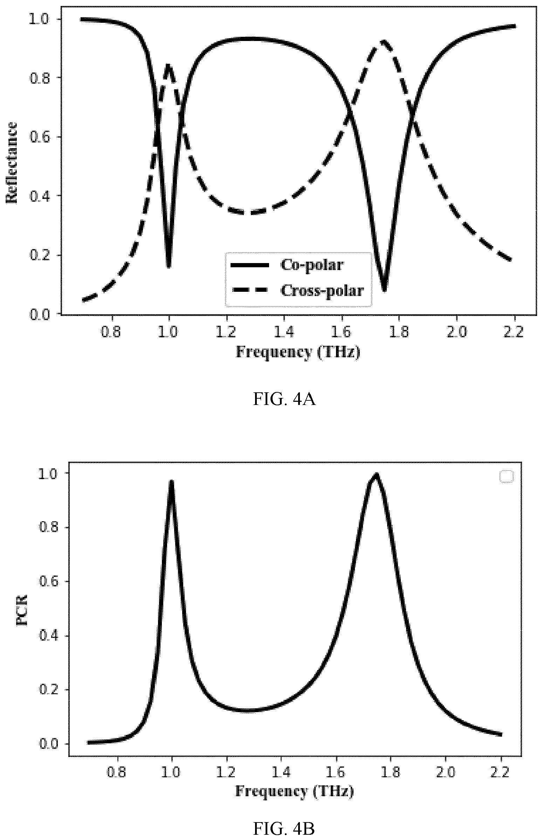

FIG. 4A is a graph showing an exemplary comparison of a co-polar reflection coefficient and a cross-polar reflection coefficient with an operating frequency of the SRR, in accordance with some embodiments of the present disclosure. As shown in FIG. 4A, at the two distinct frequencies - 1THz and 1.745THz, the co-polar reflection coefficient drastically reduces whereas the cross-polar reflection coefficient increases significantly. These are the two frequencies at which cross polarization conversion is achieved. The extent of polarization conversion can be quantified by Polarization Conversion Ratio (PCR). FIG. 4B is a graph showing an exemplary comparison of a polarization conversion ratio (PCR) with the operating frequency of the SRR, in accordance with some embodiments of the present disclosure. From FIG. 4B, it is evident that at 1THz, PCR is 0.966, which means 96.6% of the reflected wave have polarization orthogonal to the input incidence wave. Similarly, at 1.745THz, PCR is 0.9925, which means 99.25% of the reflected wave have polarization orthogonal to the input incidence wave.

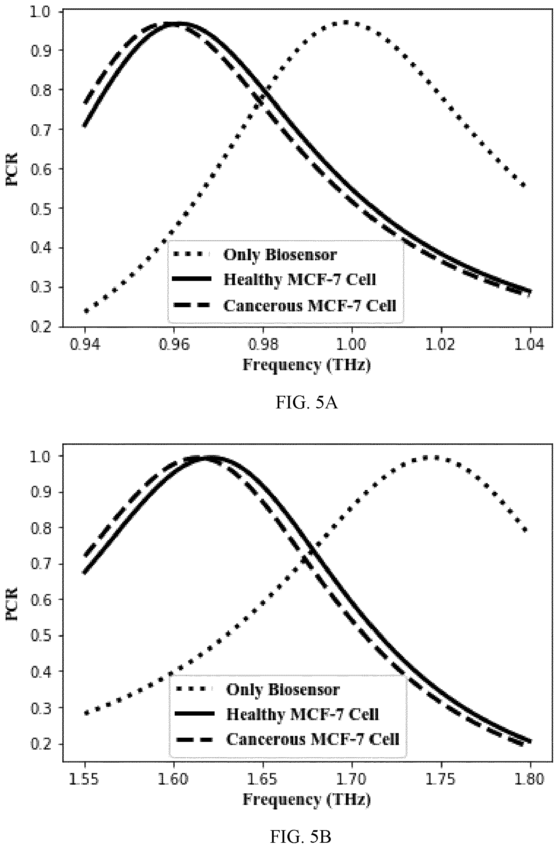

FIG. 5A is a graph showing an exemplary shift in the PCR response when the healthy and a cancerous MCF-7 cell is introduced on the top layer 302 of the SRR 300, at first resonance, in accordance with some embodiments of the present disclosure. FIG. 5B is a graph showing an exemplary shift in the PCR response when the healthy and the cancerous MCF-7 cell is introduced on the top layer 302 of the SRR 300, at second resonance, in accordance with some embodiments of the present disclosure. From FIG. 5A and FIG. 5B, it is observed that as the refractive index (RI) of the surrounding medium is increasing, the first and the second resonant frequencies decrease. The sensitivity ($S$) and the figure-of merit ($FoM$) at first resonance is 0.155 THz/RIU and 3.1 respectively, where RIU mean the refractive index unit. The sensitivity ($S$) and the figure-of merit ($FoM$) at the second resonance is 0.35 THz/RIU and 2.84 respectively.

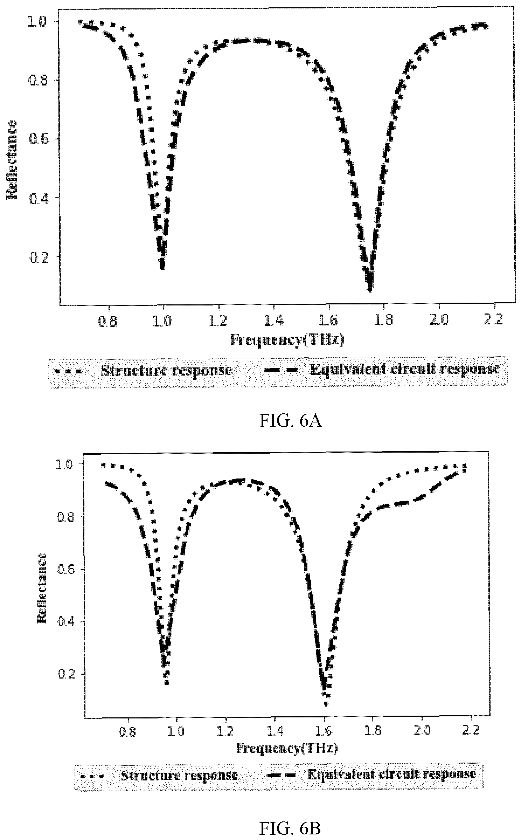

FIG. 6A is a graph showing an exemplary comparison of the co-polar reflection coefficient response of the optimal dual-band metamaterial polarization converter without the analyte layer, and the resultant response of the equivalent circuit model, in accordance with some embodiments of the present disclosure. FIG. 6B is a graph showing an exemplary comparison of the co-polar reflection coefficient response of the optimal dual-band metamaterial polarization converter with the 1 μm analyte layer having the cancerous MCF-7 cells, and the resultant response of the equivalent circuit model, in accordance with some embodiments of the present disclosure. From FIG. 6A and FIG. 6B, it is observed that there is a very good agreement between the response of the optimal dual-band metamaterial polarization converter and the response of the equivalent circuit model as the resonant frequencies from FIG. 6A and the shift in resonance in FIG. 6B of both the optimal dual-band metamaterial polarization converter and the equivalent circuit model is identical.

The embodiments of present disclosure herein address unresolved problem of designing an optimal dual-band metamaterial polarization converter that operates at a desired frequency, achieving the cross-polarization conversion. The optimal dual-band metamaterial polarization converter is designed with a single split-ring generator as a unit cell and hence the fabrication of the optimal dual-band metamaterial polarization converter is simple.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. **Also, the words "comprising," "having," "containing," and "including," and other** similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," **"an," and "the" include plural references unless the context clearly dictates otherwise.**

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. **The term "computer-readable medium" should** be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

**Claims**

1. A processor-implemented method (200) for designing an optimal dual-band metamaterial polarization converter, comprising the steps of:

   designing, via one or more hardware processors, a circular split-ring resonator (SRR) as a unit cell, having initial values of one or more key design parameters of the SRR, using a simulation model, wherein the SRR comprises a substrate layer sandwiched between a top layer and a bottom layer, and wherein the top layer comprises two capacitive gaps (202);
   aligning, via the one or more hardware processors, the two capacitive gaps of the top layer, at 180 degrees with respect to each other and at 45 degrees with respect to X-axis and Y-axis, to enable a cross-polarization conversion independent of a polarization direction of an incoming electromagnetic wave (204); and
   step-by-step tuning, via the one or more hardware processors, the initial values of the one or more key design parameters of the SRR, until an optimum frequency response is satisfied, to obtain the optimal dual-band metamaterial polarization converter with optimal values of the one or more key design parameters of the SRR (206).

2. The method of claim 1, further comprising:
   checking, via the one or more hardware processors, a stability of the optimal dual-band metamaterial polarization converter using a parametric study, by varying the one or more key design parameters, within a predefined range (208).

3. The method of claim 1, further comprising:

   introducing, via the one or more hardware processors, a target layer on the optimal dual-band metamaterial polarization converter, to calculate one or more sensing performance metrics from a shifted response, wherein the target layer comprises a plurality of samples with varying refractive index (RI) values (210); and
   validating, via the one or more hardware processors, the shifted response of the optimal dual-band metamaterial polarization converter, using an equivalent circuit model of the optimal dual-band metamaterial polarization converter, based on the calculated one or more sensing performance metrics (212).

4. The method of claim 1, wherein:

   (i) the substrate layer is made up of a di-electric material with a predefined dielectric constant;
   (ii) the top layer and the bottom layer are made up of a metal; and
   (iii) the bottom layer is a reflective layer.

5. The method of claim 1, wherein the one or more key design parameters of the SRR comprises: an inner radius of the top layer, an outer radius of the top layer, a width of the top layer, a thickness of the substrate layer, and a width of each of the two capacitive gaps of the top layer.

6. The method of claim 1, wherein step-by-step tuning the initial values of the one or more key design parameters of the SRR, comprises:

   (i) randomly adjusting an initial value of the width of the top layer, to obtain a successive value of the width of the top layer, by fixing the initial value of the inner radius of the top layer;
   (ii) calculating a successive value of the outer radius of the top layer, based on the initial value of the inner radius of the top layer and the successive value of the width of the top layer;
   (iii) iteratively changing the thickness of the substrate layer;
   (iv) iteratively changing the width of each of two capacitive gaps of the top layer;
   (v) obtaining a successive value of the inner radius of the top layer; and
   (vi) repeating the steps (i) through (v), considering the successive value of the width of the top layer as the initial value and the successive value of the inner radius of the top layer as the initial value, until the optimum frequency response is satisfied.

7. The method of claim 1, wherein the optimum frequency response comprises a co-polar reflection coefficient close to zero and a cross-polar reflection coefficient close to 1, at resonant frequencies.

8. A system (100) for designing an optimal dual-band metamaterial polarization converter, comprising:

> a memory (102) storing instructions;
> one or more input/output (I/O) interfaces (106); and
> one or more hardware processors (104) coupled to the memory (102) via the one or more I/O interfaces (106), wherein the one or more hardware processors (104) are configured by the instructions to:
>
> > design a circular split-ring resonator (SRR) as a unit cell, having initial values of one or more key design parameters of the SRR, using a simulation model, wherein the SRR comprises a substrate layer sandwiched between a top layer and a bottom layer, and wherein the top layer comprises two capacitive gaps;
> > align the two capacitive gaps of the top layer, at 180 degrees with respect to each other and at 45 degrees with respect to X-axis and Y-axis, to enable a cross- polarization conversion independent of a polarization direction of an incoming electromagnetic wave; and
> > step-by-step tuning the initial values of the one or more key design parameters of the SRR, until an optimum frequency response is satisfied, to obtain the optimal dual-band metamaterial polarization converter with optimal values of the one or more key design parameters of the SRR.

9. The system of claim 8, wherein the one or more hardware processors (104) are further configured to check a stability of the optimal dual-band metamaterial polarization converter using a parametric study, by varying the one or more key design parameters, within a predefined range.

10. The system of claim 8, wherein the one or more hardware processors (104) are further configured to:

> introduce a target layer on the optimal dual-band metamaterial polarization converter, to calculate one or more sensing performance metrics from a shifted response, wherein the target layer comprises a plurality of samples with varying refractive index (RI) values; and
> validate the shifted response of the optimal dual-band metamaterial polarization converter, using an equivalent circuit model of the optimal dual-band metamaterial polarization converter, based on the calculated one or more sensing performance metrics.

11. The system of claim 8, wherein:

> (i) the substrate layer is made up of a di-electric material with a predefined dielectric constant;
> (ii) the top layer and the bottom layer are made up of a metal; and
> (iii) the bottom layer is a reflective layer.

12. The system of claim 8, wherein the one or more key design parameters of the SRR comprises: an inner radius of the top layer, an outer radius of the top layer, a width of the top layer, a thickness of the substrate layer, and a width of each of the two capacitive gaps of the top layer.

13. The system of claim 8, wherein the one or more hardware processors (104) are configured to step-by-step tuning the initial values of the one or more key design parameters of the SRR, by:

> (i) randomly adjusting an initial value of the width of the top layer, to obtain a successive value of the width of the top layer, by fixing the initial value of the inner radius of the top layer;
> (ii) calculating a successive value of the outer radius of the top layer, based on the initial value of the inner radius of the top layer and the successive value of the width of the top layer;
> (iii) iteratively changing the thickness of the substrate layer;
> (iv) iteratively changing the width of each of two capacitive gaps of the top layer;
> (v) obtaining a successive value of the inner radius of the top layer; and
> (vi) repeating the steps (i) through (v), considering the successive value of the width of the top layer as the initial value and the successive value of the inner radius of the top layer as the initial value, until the optimum frequency response is satisfied.

14. The system of claim 8, wherein the optimum frequency response comprises a co-polar reflection coefficient close to zero and a cross-polar reflection coefficient close to 1, at resonant frequencies.

15. One or more non-transitory machine-readable information storage mediums comprising one or more instructions which when executed by one or more hardware processors cause:

designing, a circular split-ring resonator (SRR) as a unit cell, having initial values of one or more key design parameters of the SRR, using a simulation model, wherein the SRR comprises a substrate layer sandwiched between a top layer and a bottom layer, and wherein the top layer comprises two capacitive gaps;

aligning, the two capacitive gaps of the top layer, at 180 degrees with respect to each other and at 45 degrees with respect to X-axis and Y-axis, to enable a cross- polarization conversion independent of a polarization direction of an incoming electromagnetic wave;

step-by-step tuning, the initial values of the one or more key design parameters of the SRR, until an optimum frequency response is satisfied, to obtain the optimal dual-band metamaterial polarization converter with optimal values of the one or more key design parameters of the SRR;

checking, a stability of the optimal dual-band metamaterial polarization converter using a parametric study, by varying the one or more key design parameters, within a predefined range;

introducing, a target layer on the optimal dual-band metamaterial polarization converter, to calculate one or more sensing performance metrics from a shifted response, wherein the target layer comprises a plurality of samples with varying refractive index (RI) values; and

validating, the shifted response of the optimal dual-band metamaterial polarization converter, using an equivalent circuit model of the optimal dual-band metamaterial polarization converter, based on the calculated one or more sensing performance metrics.

**Amended claims in accordance with Rule 137(2) EPC.**

**1.** A processor-implemented method (200) for designing an optimal dual-band metamaterial polarization converter, comprising:

designing (202), via one or more hardware processors (104), a circular single split-ring resonator, SRR, (300) as a unit cell, having initial values of one or more key design parameters of the SRR (300), using a simulation model, wherein the SRR (300) comprises a substrate layer (304) sandwiched between a top layer (302) and a bottom layer (306), and wherein the top layer (302) comprises two capacitive gaps;

aligning (204), via the one or more hardware processors (104), the two capacitive gaps of the top layer (302), at 180 degrees with respect to each other and at 45 degrees with respect to X-axis and Y-axis, to enable a cross-polarization conversion independent of a polarization direction of an incoming electromagnetic wave, wherein size of the SRR (300) is smaller than an operating wavelength of the incoming electromagnetic wave; and

step-by-step tuning (206), via the one or more hardware processors (104), the initial values of the one or more key design parameters of the SRR (300), until an optimum frequency response is satisfied, to obtain the optimal dual-band metamaterial polarization converter with optimal values of the one or more key design parameters of the SRR (300),

wherein step-by-step tuning (206) the initial values of the one or more key design parameters of the SRR (300), comprises:

(i) randomly adjusting an initial value of the width of the top layer (302), to obtain a successive value of the width of the top layer (302), by fixing the initial value of the inner radius of the top layer (302);

(ii) calculating a successive value of the outer radius of the top layer (302), based on the initial value of the inner radius of the top layer (302) and the successive value of the width of the top layer (302);

(iii) iteratively changing the thickness of the substrate layer (304);

(iv) iteratively changing the width of each of two capacitive gaps of the top layer (302);

(v) obtaining a successive value of the inner radius of the top layer (302); and

(vi) repeating the steps (i) through (v), considering the successive value of the width of the top layer (302) as the initial value and the successive value of the inner radius of the top layer (302) as the initial value, until the optimum frequency response is satisfied.

**2.** The method (200) of claim 1, further comprising:
checking (208), via the one or more hardware processors (104), a stability of the optimal dual-band metamaterial polarization converter using a parametric study, by varying the one or more key design parameters, within a predefined range.

**3.** The method (200) of claim 1, further comprising:

introducing (210), via the one or more hardware processors (104), a target layer on the optimal dual-band metamaterial polarization converter, to calculate one or more sensing performance metrics from a shifted response, wherein the target layer comprises a plurality of samples with varying refractive index, RI, values; and validating (212), via the one or more hardware processors (104), the shifted response of the optimal dual-band metamaterial polarization converter, using an equivalent circuit model of the optimal dual-band metamaterial polarization converter, based on the calculated one or more sensing performance metrics.

**4.** The method (200) of claim 1, wherein:

(i) the substrate layer (304) is made up of a di-electric material with a predefined dielectric constant;
(ii) the top layer (302) and the bottom layer (306) are made up of a metal; and
(iii) the bottom layer (306) is a reflective layer.

**5.** The method (200) of claim 1, wherein the one or more key design parameters of the SRR (300) comprises: an inner radius of the top layer (302), an outer radius of the top layer (302), a width of the top layer (302), a thickness of the substrate layer (304), and a width of each of the two capacitive gaps of the top layer (302).

**6.** The method (200) of claim 1, wherein the optimum frequency response comprises a co-polar reflection coefficient close to zero and a cross-polar reflection coefficient close to 1, at resonant frequencies.

**7.** A system (100) for designing an optimal dual-band metamaterial polarization converter, comprising:

a memory (102) storing instructions;
one or more input/output, I/O, interfaces (106); and
one or more hardware processors (104) coupled to the memory (102) via the one or more I/O interfaces (106), wherein the one or more hardware processors (104) are configured by the instructions to:

design a circular single split-ring resonator, SRR, (300) as a unit cell, having initial values of one or more key design parameters of the SRR (300), using a simulation model, wherein the SRR (300) comprises a substrate layer (304) sandwiched between a top layer (302) and a bottom layer (306), and wherein the top layer (302) comprises two capacitive gaps;
align the two capacitive gaps of the top layer (302), at 180 degrees with respect to each other and at 45 degrees with respect to X-axis and Y-axis, to enable a cross- polarization conversion independent of a polarization direction of an incoming electromagnetic wave, wherein size of the SRR (300) is smaller than an operating wavelength of the incoming electromagnetic wave; and
step-by-step tune the initial values of the one or more key design parameters of the SRR (300), until an optimum frequency response is satisfied, to obtain the optimal dual-band metamaterial polarization converter with optimal values of the one or more key design parameters of the SRR (300), wherein the one or more hardware processors (104) are configured to step-by-step tune the initial values of the one or more key design parameters of the SRR (300), by:

(i) randomly adjusting an initial value of the width of the top layer (302), to obtain a successive value of the width of the top layer (302), by fixing the initial value of the inner radius of the top layer (302);
(ii) calculating a successive value of the outer radius of the top layer (302), based on the initial value of the inner radius of the top layer (302) and the successive value of the width of the top layer (302);
(iii) iteratively changing the thickness of the substrate layer (304);
(iv) iteratively changing the width of each of two capacitive gaps of the top layer (302);
(v) obtaining a successive value of the inner radius of the top layer (302); and
(vi) repeating the steps (i) through (v), considering the successive value of the width of the top layer (302) as the initial value and the successive value of the inner radius of the top layer (302) as the initial value, until the optimum frequency response is satisfied.

**8.** The system (100) of claim 7, wherein the one or more hardware processors (104) are further configured to check a stability of the optimal dual-band metamaterial polarization converter using a parametric study, by varying the one or more key design parameters, within a predefined range.

9. The system (100) of claim 7, wherein the one or more hardware processors (104) are further configured to:

    introduce a target layer on the optimal dual-band metamaterial polarization converter, to calculate one or more sensing performance metrics from a shifted response, wherein the target layer comprises a plurality of samples with varying refractive index, RI, values; and
    validate the shifted response of the optimal dual-band metamaterial polarization converter, using an equivalent circuit model of the optimal dual-band metamaterial polarization converter, based on the calculated one or more sensing performance metrics.

10. The system (100) of claim 7, wherein:

    (i) the substrate layer (304) is made up of a di-electric material with a predefined dielectric constant;
    (ii) the top layer (302) and the bottom layer (306) are made up of a metal; and
    (iii) the bottom layer (306) is a reflective layer.

11. The system (100) of claim 7, wherein the one or more key design parameters of the SRR (300) comprises: an inner radius of the top layer (302), an outer radius of the top layer (302), a width of the top layer (302), a thickness of the substrate layer (304), and a width of each of the two capacitive gaps of the top layer (302).

12. The system (100) of claim 7, wherein the optimum frequency response comprises a co-polar reflection coefficient close to zero and a cross-polar reflection coefficient close to 1, at resonant frequencies.

13. One or more non-transitory machine-readable information storage mediums (102) comprising one or more instructions which when executed by one or more hardware processors (104) cause:

    designing, a circular single split-ring resonator, SRR, (300) as a unit cell, having initial values of one or more key design parameters of the SRR (300), using a simulation model, wherein the SRR (300) comprises a substrate layer (304) sandwiched between a top layer (302) and a bottom layer (306), and wherein the top layer (302) comprises two capacitive gaps;
    aligning, the two capacitive gaps of the top layer (302), at 180 degrees with respect to each other and at 45 degrees with respect to X-axis and Y-axis, to enable a cross- polarization conversion independent of a polarization direction of an incoming electromagnetic wave, wherein size of the SRR (300) is smaller than an operating wavelength of the incoming electromagnetic wave;
    step-by-step tuning, the initial values of the one or more key design parameters of the SRR (300), until an optimum frequency response is satisfied, to obtain the optimal dual-band metamaterial polarization converter with optimal values of the one or more key design parameters of the SRR (300);
    checking, a stability of the optimal dual-band metamaterial polarization converter using a parametric study, by varying the one or more key design parameters, within a predefined range;
    introducing, a target layer on the optimal dual-band metamaterial polarization converter, to calculate one or more sensing performance metrics from a shifted response, wherein the target layer comprises a plurality of samples with varying refractive index, RI, values; and
    validating, the shifted response of the optimal dual-band metamaterial polarization converter, using an equivalent circuit model of the optimal dual-band metamaterial polarization converter, based on the calculated one or more sensing performance metrics,

    wherein step-by-step tuning the initial values of the one or more key design parameters of the SRR (300), comprises:

    (i) randomly adjusting an initial value of the width of the top layer (302), to obtain a successive value of the width of the top layer (302), by fixing the initial value of the inner radius of the top layer (302);
    (ii) calculating a successive value of the outer radius of the top layer (302), based on the initial value of the inner radius of the top layer (302) and the successive value of the width of the top layer (302);
    (iii) iteratively changing the thickness of the substrate layer (304);
    (iv) iteratively changing the width of each of two capacitive gaps of the top layer (302);
    (v) obtaining a successive value of the inner radius of the top layer (302); and
    (vi) repeating the steps (i) through (v), considering the successive value of the width of the top layer (302) as the initial value and the successive value of the inner radius of the top layer (302) as the initial value, until the optimum frequency response is satisfied.

System **100**

**108**

Memory **102**

Modules **102a**

Repository **102b**

I/O interface(s) **106**

Hardware processor(s) **104**

FIG. 1

200

Design a circular split-ring resonator (SRR) as a unit cell, having initial values of one or more key design parameters of the SRR, using a simulation model, wherein the SRR comprises a substrate layer sandwiched between a top layer and a bottom layer, and wherein the top layer comprises two capacitive gaps **202**

Align the two capacitive gaps of the top layer, at 180 degrees with respect to each other and at 45 degrees with respect to X-axis and Y-axis, to enable a cross-polarization conversion independent of a polarization direction of an incoming electromagnetic wave **204**

Step-by-step tuning the initial values of the one or more key design parameters of the SRR, until an optimum frequency response is satisfied, to obtain the optimal dual-band metamaterial polarization converter with optimal values of the one or more key design parameters of the SRR **206**

Check a stability of the optimal dual-band metamaterial polarization converter using a parametric study, by varying the one or more key design parameters, within a predefined range **208**

Introduce a target layer on the optimal dual-band metamaterial polarization converter, to calculate one or more sensing performance metrics from a shifted response, wherein the target layer comprises a plurality of samples with varying refractive index (RI) values **210**

Validate the shifted response of the optimal dual-band metamaterial polarization converter, using an equivalent circuit model of the optimal dual-band metamaterial polarization converter, based on the calculated one or more sensing performance metrics **212**

FIG. 2

300

w

$G_1$

$R_{in}$

$R_{out}$

$G_2$

Top layer **302**

Bottom layer **306**

(A)

(B)

Substrate layer **304**

$T_s$

(C)

FIGS. 3A-3C

FIG. 4A

FIG. 4B

FIG. 5A

FIG. 5B

FIG. 6A

FIG. 6B

Europäisches
Patentamt

European
Patent Office

Office européen
des brevets

# EUROPEAN SEARCH REPORT

Application Number

EP 22 21 2893

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | XU ZHENHUA ET AL: "Terahertz broadband polarization converter based on the double-split ring resonator metasurface", SN APPLIED SCIENCES, [Online] vol. 3, no. 9, 2 August 2021 (2021-08-02), XP093047309, ISSN: 2523-3963, DOI: 10.1007/s42452-021-04751-w Retrieved from the Internet: URL:https://link.springer.com/article/10.1007/s42452-021-04751-w/fulltext.html> [retrieved on 2023-05-16] | 1,2,4-9, 11-15 | INV. H01Q5/321 H01Q15/00 H01Q15/22 G01N27/22 G01N21/3581 |
| Y | * page 1 – page 7 * ----- | 3,10 | |
| Y | US 2020/371022 A1 (AL-NAIB IBRAHEEM ABDALWAHHAB IBRAHEEM [SA]) 26 November 2020 (2020-11-26) * paragraph [0049] * * paragraph [0060] * ----- | 3,10 | |
| A | LI FENGXIA ET AL: "Compact High-Efficiency Broadband Metamaterial Polarizing Reflector at Microwave Frequencies", IEEE TRANSACTIONS ON MICROWAVE THEORY AND TECHNIQUES, IEEE, USA, vol. 67, no. 2, 4 December 2018 (2018-12-04), pages 606-614, XP011708194, ISSN: 0018-9480, DOI: 10.1109/TMTT.2018.2881967 [retrieved on 2019-02-04] * page 606 – page 614; figure 1 * ----- | 1-15 | TECHNICAL FIELDS SEARCHED (IPC) H01Q |

The present search report has been drawn up for all claims

| Place of search | Date of completion of the search | Examiner |
|---|---|---|
| The Hague | 16 May 2023 | Collado Garrido, Ana |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT**
**ON EUROPEAN PATENT APPLICATION NO.**

EP 22 21 2893

This annex lists the patent family members relating to the patent documents cited in the above-mentioned European search report.
The members are as contained in the European Patent Office EDP file on
The European Patent Office is in no way liable for these particulars which are merely given for the purpose of information.

16-05-2023

| Patent document cited in search report | Publication date | Patent family member(s) | Publication date |
|---|---|---|---|
| US 2020371022 A1 | 26-11-2020 | US 2020371022 A1 | 26-11-2020 |
| | | US 2021239611 A1 | 05-08-2021 |
| | | US 2022283084 A1 | 08-09-2022 |
| | | US 2023097684 A1 | 30-03-2023 |

EPO FORM P0459

For more details about this annex : see Official Journal of the European Patent Office, No. 12/82

**EP 4 293 827 A1**